(19) Europäisches Patentamt
European Patent Office
Office européen des brevets

(11) Veröffentlichungsnummer : **0 081 766**
**B1**

(12) # EUROPÄISCHE PATENTSCHRIFT

(45) Veröffentlichungstag der Patentschrift : **07.08.85**

(51) Int. Cl.[4] : **C 09 K 11/06**, C 09 B 5/62, C 08 K 5/00, H 01 L 31/02

(21) Anmeldenummer : **82111188.7**

(22) Anmeldetag : **03.12.82**

(54) **Lichtsammelsysteme unter Verwendung von halogenierten Perylenderivaten als Lichtwandler.**

(30) Priorität : **15.12.81 DE 3149620**

(43) Veröffentlichungstag der Anmeldung : **22.06.83 Patentblatt 83/25**

(45) Bekanntmachung des Hinweises auf die Patenterteilung : **07.08.85 Patentblatt 85/32**

(84) Benannte Vertragsstaaten : **CH DE FR GB IT LI NL**

(56) Entgegenhaltungen :
**EP-A- 0 033 079**
**EP-A- 0 061 092**
**DE-A- 2 139 690**
**DE-A- 2 451 782**
**DE-A- 2 519 790**
**DE-A- 2 851 513**
**DE-A- 3 016 765**

(73) Patentinhaber : **BAYER AG**
**Konzernverwaltung RP Patentabteilung**
**D-5090 Leverkusen 1 Bayerwerk (DE)**

(72) Erfinder : **Claussen, Uwe, Dr.**
**Carl-Rumpff-Strasse 29**
**D-5090 Leverkusen 1 (DE)**

**EP 0 081 766 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Vorrichtungen zum Sammeln diffuser elektromagnetischer Strahlung durch Ausnützen der Fluoreszenz sind bekannt. Kernstück der Sammler ist ein gegenüber der Umgebung optisch dichteres Medium, das fluoreszenzfähige Zentren enthält (DE-OS-2 620 115).

Die ökonomische Verwendbarkeit eines Lichtsammelsystems wird in hohen Maße von der Brauchbarkeit des in ihm als Lichtwandler eingesetzten Farbstoffs bestimmt. An die optische Qualität dieses Farbstoffs werden extreme Anforderungen gestellt (Festkörperprobleme XIX, 427 (1979)).

Die Erfindung betrifft ein neues Lichtsammelsystem, das dadurch gekennzeichnet ist, daß es ein Gemisch von Farbstoffen der Formel

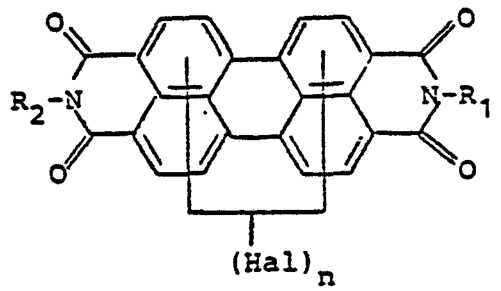

(I)

in der

Hal gleiche oder verschiedene Halogenatome aus der Reihe Fluor, Chlor, Brom,
$R_1$, $R_2$ Wasserstoff oder gegebenenfalls substituiertes $C_1$-$C_{18}$-Alkyl und
n 4-5 bezeichnen,

bestehend aus 1 bis 20 Gew.-% des Pentahalogenderivats, insbesondere des Pentachlorderivats und 99 bis 80 Gew.-% des Tetrahalogenderivats, insbesondere des Tetrachlorderivats in einem lichtdurchlässigen, optisch verwendbaren Kunststoff gelöst, enthält.

Die Alkylreste können beispielsweise durch $C_1$-$C_{10}$-Alkoxy, $C_1$-$C_{10}$-Alkylthio, Halogen, insbesondere Cl, Br oder F und Cyan substituiert sein. Von großer Bedeutung sind auch perhalogenierte, insbesondere perfluorierte Alkylreste $R_1$ und $R_2$. Insbesondere bezeichnen $R_1$, $R_2$ einen gegebenenfalls substituierten $C_1$-$C_6$-Alkylrest wie Methyl, Ethyl, Propyl, Butyl, Pentyl, Hexyl.

Bevorzugt eingesetzt werden Verbindungen der Formeln II-III

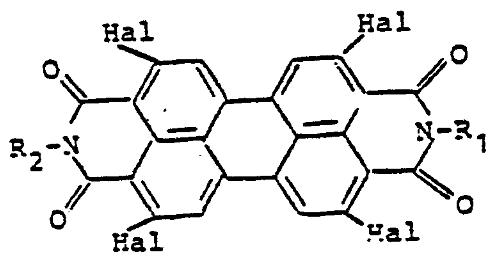

(II)

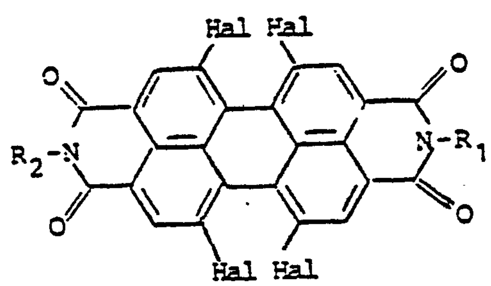

(III)

In den Formeln II und III haben Hal, $R_1$ und $R_2$ die zu Formel I angegebenen Bedeutungen.

Die erfindungsgemäß verwendbaren Produkte sind bekannt (DE-PS-394 794, DE-PS-441 587, DE-OS-2 455 782 und DE-OS-2 519 790) oder lassen sich in Analogie zu literaturbekannten Verfahren aus bekannten Ausgangsverbindungen herstellen (s. z. B. DE-PS-386 057 und DE-OS-2 455 785).

Die nach bekannten Verfahren erhältlichen halogenierten Perylenderivate sind in vielen Fällen für den erfindungsgemäßen Zweck nicht einsetzbar. Die üblichen, für die Verwendung der Farbstoffe zur Massefärbung von Kunststoffen ausreichenden Reinigungsverfahren wie Umfällen aus Schwefelsäure oder Auskochen mit Sodalösung (s. z. B. DE-OS-2 139 688) sind für die Verwendung der Farbstoffe in Lichtsammelsystemen in der Regel unzureichend.

Die hier erforderliche Reinigung gelingt durch Absorptionschromatographie an Kieselgel. Gegebenenfalls muß dieses Verfahren mehrfach wiederholt werden.

Zur Herstellung größere Mengen der reinen Farbstoffe eignen sich insbesondere die fraktionierte Kristallisation oder eine reaktive Reinigung, vorzugsweise eine Kombination beider Maßnahmen.

Dabei wird das Rohprodukt mit einer basisch wirkenden Substanz, vorzugsweise einem Amin, verrührt. Es ist zweckmäßig, das Amin durch ein aprotonisches Lösungsmittel zu verdünnen.

Die Menge des Amins kann in weiten Grenzen schwanken, gut geeignet hat sich ein Einsatz von ca. 10 % Amin bezogen auf das eingesetzte Produktgewicht erwiesen. Die Reaktion wird bei Raumtemperatur bis 180 °C ausgeführt, wobei die Konzentration des Amin, umso kleiner sein sollte, je höher die Temperatur gewählt wird.

Als Amine kommen primäre, sekundäre oder tertiäre aliphatische, aromatische oder heterocyclische Amine in Frage.

Es ist zweckmäßig, solche Amine einzusetzen, die sich leicht destillativ oder durch Waschen mit Wasser entfernen lassen. Das optimal geeignete Amin und auch die Reaktionsbedingungen sind von der Reinigungsaufgabe abhängig. Diese Werte lassen sich leicht durch Handversuche ermitteln. Ein breites anwendbares System enthält Methylethylketon und Cyclohexylamin im Verhältnis 9 : 1. Man läßt dieses Gemisch 45 min unter Rückfluß auf das gelöste oder fein suspendierte Rohprodukt einwirken.

Die anschließende fraktionierte Kristallisation führt man zweckmäßig mit aprotonischen Lösungsmitteln, wie DMF, DMSO, N-Methylpyrrolidon, Sulfolan, a. ä. vorzugsweise aber mit Nitrobenzol oder Phenolethern aus.

Die Erfindung betrifft vorzugsweise ein Lichtsammelsystem, das dadurch gekennzeichnet ist, das es ein Gemisch von Farbstoffen der Formel I enthält, die in einer 0,5-2 mM Lösung in Schichtdicken von 10 cm einen Anstieg der Transmission von 0 auf 95 % bei einer Änderung der Wellenlänge von 25-120 nm, vorzugsweise 35-100 nm aufweisen. Diese optische Messung erfolgt in einem Lösungsmittel, das im Meßbereich frei von Eigenabsorption ist und mit dem Farbstoff keine gefärbten Komplexe bildet. Je nach Farbstoff kommen beispielsweise $CHCl_3$, $CH_2Cl_2$ oder Dimethylformamid in Frage.

Die neuen Lichtsammelsysteme, bei denen es sich um Systeme der genannten Farbstoffe in Matrizen geeigneter Geometrie, d. h. optischen Systemen, bei denen das Verhältnis von Emissions- zu Absorptionsflächen 1 : 10 bis 1 : 1 000 betragen kann, handelt, sind geeignet, einfallende diffuse elektromagnetische Strahlung zu absorbieren und in einem gegenüber der Umgebung optisch dichteren Medium nahezu verlustlos zu emittieren, wobei der Hauptteil des Emissionslichtes total reflektiert im Medium verbleibt.

Nur der Anteil der emittierten Lichtes, dessen Emissionsbande weitgehend frei von Absorption ist, ist für den erfindungsgemäßen Zweck nutzbar.

Die neuen Lichtsammelsysteme können z. B. in Verbindung mit photovoltaischen Elementen zur Umwandlung von Lichtenergie in elektrischen Strom verwendet werden (Festkörperprobleme XIX, 427, *1979*). Daneben eignen sie sich zur Helligkeitsverstärkung von optoelektronischen Anzeigevorrichtungen (DE-OS-2 554 226) oder ohne elektronische Bauteile zu vielerlei Anzeige-, Hinweis oder Markierungszwecken, z. B. in passiven Anzeigenelementen, Displays, Verkehrszeichen, Ampeln, Sicherheitseinrichtungen, Schaltern, Szintillatoren.

Die erfindungsgemäßen Lichtsammelsysteme enthalten das Farbstoffgemisch in einem lichtdurchlässigen, optisch verwendbaren Kunststoff gelöst, wobei je nach Einsatzgebiet des Lichtsammelsystems, verschiedenste geometrische Formen in Frage kommen. Geeignete Kunststoffe, wie sie z. B. zum Sammeln von Licht in Verbindung mit Solarzellen und in passiven Anzeigeelementen eingesetzt werden, sind Homo- und Copolymerisate der Acrylsäure oder ihrer Derivate z. B. Polymethylmethacrylat, Celluloseester z. B. Cellulosepropionat, Celluloseacetat und Cellulosebutyrat, Polyvinylchlorid, Polycarbonate, Styrol-Acrylnitril-Polymerisate, Polystyrol.

Die erfindungsgemäße Verwendung der Farbstoffgemische der Formel (I) ist im hohen Maße vorteilhaft, da sie neben einer guten Quantenausbeute und einem hohen Verstärkungsfaktor ausgezeichnete Lichtechtheit aufweisen und damit eine ökonomische Verwendbarkeit der neuen Lichtsammelsysteme gewährleisten. Der Einsatz der Farbstoffgemische führt insbesondere zur Verbesserung der Löslichkeit in den Kunststoffmedien.

Die DE-A-2 851 513 beschreibt Lichtsammelsysteme, die halogenierte Perylentetracarbonsäurediimide enthalten, enthält jedoch keinen Hinweis auf die Eignung von Gemischen aus Tetra- und Pentahalogenderivaten. Es ist überraschend, daß die Farbstoffgemische zur Verbesserung der Löslichkeit in den Kunststoffmedien führen.

## Beispiel 1

190 g N,N'-Dimethyl-perylen-3,4,9,10-tetracarbonsäurediimid technischer Reinheit werden in 800 g Chlorsulfonsäure gelöst und bei 25 °C durch Einleiten von 210 g Chlor in Gegenwart von Jod chloriert.

Nach Austragen auf Eis wird abgesaugt, einmal mit kaltem Wasser gewaschen und der Nutschkuchen in 1 l Wasser verrührt. Man stumpft die Säure mit 10 %iger Natronlauge ab, stellt einen angenähert neutralen pH-Wert ein und saugt erneut ab.

Die Operation wird wiederholt, jedoch wird jetzt mit 10 %iger Sodalösung ein pH-Wert von 9,5

eingestellt. Nach dem Absaugen und Waschen mit Wasser wird der Rückstand in 1 l Methylethylketon suspendiert, das 100 g Cyclohexylamin enthält. Man erwärmt 2 h unter Rückfluß und saugt heiß ab. Der Rückstand wird mit Methylethylketon, darauf mit Methanol und Wasser gewaschen. Man erhält ein dunkelbraunrotes Produkt, das kein N,N'-Dimethyl-hexachlorperylen-3,4,9,10-tetracarbonsäurediimid mehr enthält. Den Rest an Pentachlorverbindung entfernt man durch doppelte Kristallisation aus Dimethylformamid und schließlich aus Nitrobenzol. Man erhält 124 g eines dunkelroten, metallisch glänzenden kristallinen Produkts, bei dem es sich um N,N'-Dimethyl-tetrachlorperylen-3,4,9,10-tetracarbonsäurediimid handelt.

Aus den Mutterlaugen der DMF-Kristallisation läßt sich durch weitere Kristallisation oder Säulenchromatographie N,N'-Dimethyl-pentachlorperylen-3,4,9,10-tetracarbonsäurediimid gewinnen.

Beispiel 2

5 g N,N'-Dimethyl-perylen-3,4,9,10-tetracarbonsäurediimid werden in 35 g Chlorsulfonsäure mit 0,5 g Jod auf 25 °C erwärmt. Man tropft 9 g Brom zu und steigert die Temperatur innerhalb 2,5 h auf 60-70 °C. Diese Temperatur hält man weitere 2 h, und rührt weitere 90 min. bei 80 °C. Eine Probe des Ansatzes ist dann vollständig in Chloroform löslich. Danach wird der Ansatz auf Eis gegeben und aufgearbeitet. Das neutrale, trockene Reaktionsprodukt wird aus Nitrobenzol kristallisiert. Man erhält 3 g rote Kristalle. Diese stellen eine Mischung verschieden hoch bromierter Produkte dar, von denen das Tetra-bromderivat den Hauptteil bildet. Durch Chromatographie an Kieselgel läßt sich das Tetrabrom-N,N'-dimethylperylen-3,4,9,10-tetracarbonsäurediimid in Form leuchtend roter Kristalle rein gewinnen.

Beispiel 3

64 g N,N'-Dimethyl-perylen-3,4,9,10-tetracarbonsäurediimid werden wie in Beispiel 1 bei 40-50 °C chloriert. Nach dem Austragen auf Eis und Waschen bis zur Neutralität erhält man 80 g Rohprodukt. Dieses wird in 4 600 ml Methoxybenzol heiß gelöst, wenig Filtrierhilfsmittel (Tonsil) hinzugefügt und heiß filtriert. Der rote, feinkristalline Niederschlag wird gesammelt, mit Methoxybenzol gewaschen und erneut aus der gleichen Menge Methoxybenzol kristallisiert. Nach dem Trocknen verbleiben 45 g eines brillantroten Niederschlags, der nach Ausweis des Massenspektrums eine Mischung aus Tetra- und Pentachlor-N,N'-dimethyl-3,4,9,10-perylentetracarbonsäurediimid darstellt. Das Molverhältnis Lösungsmittel : Farbstoff beträgt 1 : 1 und läßt sich durch Vakuumtrocknung bis auf 1 : 2 senken. Der Chlorgehalt beträgt 21,6 %, was einem Verhältnis der Tetrachlor- zur Pentachlorverbindung von etwa 9 : 1 entspricht. Diese Substanz ist in organischen Solventien bedeutend besser löslich als die reine, kristallisierte Tetrachlorverbindung.

Der Farbstoff hat in einer Konzentration von 488,8 mg/l in Methylenchlorid bei einer Schichtdicke von 10 cm bei 562 nm eine Transmission von 0,05 und bei 595 nm eine von 0,95.

**Patentansprüche**

1. Lichtsammelsystem, dadurch gekennzeichnet, daß es ein Gemisch von Farbstoffen der Formel

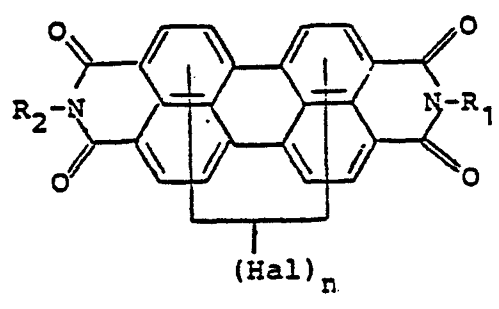

(I)

in der

Hal gleiche oder verschiedene Halogenatome aus der Reihe Fluor, Chlor oder Brom,

$R_1$, $R_2$ Wasserstoff oder gegebenenfalls substituiertes $C_1$-$C_{18}$-Alkyl und

n 4-5 bezeichnen,

bestehend aus 1 bis 20 Gew.-% des Pentahalogenderivats, insbesondere des Pentachlorderivats und 99 bis 80 Gew.-% des Tetrahalogenderivats, insbesondere des Tetrachlorderivats in einem lichtdurchlässigen, optisch verwendbaren Kunststoff gelöst, enthält.

2. Lichtsammelsystem gemäß Anspruch 1, enthaltend einen Farbstoff der Formel I, in der $R_1$, $R_2$ Wasserstoff oder gegebenenfalls durch $C_1$-$C_{10}$ Alkoxy, $C_1$-$C_{10}$-Alkylthio, Halogen, insbesondere Cl, Br oder F und/oder Cyan substituierte $C_1$-$C_{18}$-Alkylreste bezeichnen.

3. Lichtsammelsystem gemäß Anspruch 1, enthaltend einen Farbstoff der Formel I, in der $R_1$, $R_2$ für Methyl stehen.

4. Lichtsammelsystem gemäß Anspruch 1, dadurch gekennzeichnet, daß die enthaltenen Farbstoffe in einer 0,5-2 mM Lösung in Schichtdicken von 10 cm einen Anstieg der Transmission von 0 auf 95 % bei einer Änderung der Wellenlänge von 25-120 nm, vorzugsweise 35-100 nm aufweisen.

5. Lichtsammelsystem gemäß den Ansprüchen 1-4, dadurch gekennzeichnet, daß der Kunststoff ein Homo- oder Copolymerisat der Acrylsäure oder ihrer Derivate, ein Celluloseester, Polyvinylchlorid, Polycarbonat, ein Styrol- Acrylnitril-Polymerisat oder Polystyrol ist.

6. Lichtsammelsystem gemäß den Ansprüchen 1-4, dadurch gekennzeichnet, daß der Kunststoff Cellulosepropionat, Celluloseacetat oder Cellulosebutyrat ist.

7. Lichtsammelsystem gemäß den Ansprüchen 1-4, dadurch gekennzeichnet, daß der Kunststoff Polymethylmethacrylat ist.

8. Verwendung eines Lichtsammelsystems gemäß den Ansprüchen 1-7 in Verbindung mit photovoltaischen Elementen zur Umwandlung von Lichtenergie in elektrischen Strom.

**Claims**

1. Light-collecting system, characterised in that it contains a mixture of dyestuffs of the formula

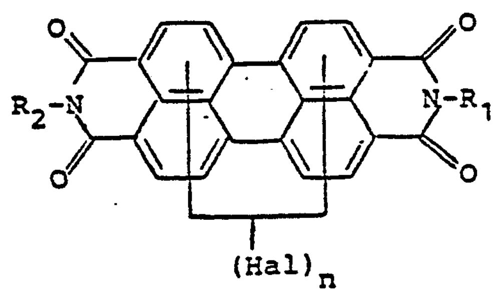

(I)

in which

Hal designates identical or different halogen atoms from the series comprising fluorine, chlorine or bromine,

$R_1$ and $R_2$ designate hydrogen or optionally substituted $C_1$-$C_{18}$-alkyl and

n designates 4-5,

consisting of 1 to 20 % by weight of the pentahalogeno derivative, in particular of the pentachloro derivative and 99 to 80 % by weight of the tetrahalogeno derivative, in particular of the tetrachloro derivative, dissolved in a transparent, optically usable plastic.

2. Light-collecting system according to Claim 1, containing a dyestuff of the formula I, in which $R_1$ and $R_2$ designate hydrogen or $C_1$-$C_{18}$-alkyl radicals optionally substituted by $C_1$-$C_{10}$-Alkoxy, $C_1$-$C_{10}$-alkylthio, halogen, in particular Cl, Br or F and/or cyano.

3. Light-collecting system according to Claim 1, containing a dyestuff of the formula I in which $R_1$ and $R_2$ represent methyl.

4. Light-collecting system according to Claim 1, characterised in that the dyestuffs contained therein display, in a 0.5-2 mM solution in path lengths of 10 cm, an increase in transmission of 0 to 95 % when the wavelength is changed by 25-120 nm, preferably 35-100 nm.

5. Light-collecting system according to Claims 1-4, characterised in that the plastic is a homo- or copolymer of acrylic acid or derivatives thereof, a cellulose ester, polyvinyl chloride, polycarbonate, a styrene-acrylonitrile polymer or polystyrene.

6. Light-collecting system according to Claims 1-4, characterised in that the plastic is cellulose propionate, cellulose acetate or cellulose butyrate.

7. Light-collecting system according to Claims 1-4, characterised in that the plastic is polymethyl methacrylate.

8. Use of a light-collecting system according to Claims 1-7, in conjunction with photovoltaic elements for converting light energy into electric current.

**Revendications**

1. Système collecteur de lumière, caractérisé en ce qu'il contient un mélange de colorants de formule

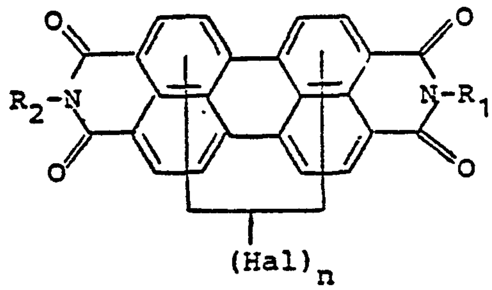

(I)

dans laquelle

Hal désigne des atomes d'halogènes égaux ou différents de la série fluor, chlore ou brome,

$R_1$, $R_2$ représentent l'hydrogène ou un groupe alkyle en $C_1$ à $C_{18}$ éventuellement substitué et

n a une valeur de 4-5,

comprenant 1 à 20 % en poids du dérivé pentahalogéné, notamment du dérivé pentachloré et 99 à 80 % en poids du dérivé tétrahalogéné, notamment du dérivé tétrachloré dissous dans une matière plastique translucide utilisable en optique.

2. Système collecteur de lumière suivant la revendication 1, contenant un colorant de formule I, dans laquelle $R_1$, $R_2$ représentent l'hydrogène ou des restes alkyle en $C_1$ à $C_{18}$ éventuellement substitués par un radical alkoxy en $C_1$ à $C_{10}$, alkylthio en $C_1$ à $C_{10}$, halogéno, notamment Cl, Br ou F et/ou cyano.

3. Système collecteur de lumière suivant la revendication 1, contenant un colorant de formule I dans laquelle $R_1$, $R_2$ représentent le groupe méthyle.

4. Système collecteur de lumière suivant la revendication 1, caractérisé en ce que les colorants contenus présentent, en solution 0,5-2 mM sous des épaisseurs de couche de 10 cm, une montée de la transmission de 0 à 95 % pour une variation de la longueur d'onde de 25 à 120 nm, de préférence 35-100 nm.

5. Système collecteur de lumière suivant les revendications 1 à 4, caractérisé en ce que la matière plastique est un homopolymère ou un copolymère d'acide acrylique ou de ses dérivés, un ester cellulosique, du chlorure de polyvinyle, un polycarbonate, un polymère de styrène-acrylonitrile ou un polystyrène.

6. Système collecteur de lumière suivant les revendications 1-4, caractérisé en ce que la matière plastique est le propionate de cellulose, l'acétate de cellulose ou le butyrate de cellulose.

7. Système collecteur de lumière suivant les revendications 1-4, caractérisé en ce que la matière plastique est un polyméthacrylate de méthyle.

8. Utilisation d'un système collecteur de lumière suivant les revendications 1-7, en relation avec des éléments photovoltaïques pour convertir de l'énergie lumineuse en courant électrique.